# EUROPEAN PATENT SPECIFICATION

(11) **EP 1 947 645 B1**
(45) Date of publication and mention of the grant of the patent: **30.09.2009**
(21) Application number: 08155426.3
(22) Date of filing: 13.03.2003
(51) Int. Cl.: G11B 7/26, G11B 7/24, C23C 14/34, G11B 7/258

(54) **Silver alloy sputtering target for forming reflective layer of optical recording medium**
Sputtertarget aus Silberlegierung zur Bildung einer reflektierenden Schicht auf einem optischen Aufzeichnungsmedium
Cible de pulvérisation d'alliage d'argent pour la formation d'une couche réfléchissante d'un support d'enregistrement optique

(43) Date of publication of application: 23.07.2008
(62) Divisional of application: 03712681.0
(73) Proprietor: Mitsubishi Materials Corporation, Chiyoda-ku Tokyo (JP)
(72) Inventor: Mishima, Akifumi, Sanda-shi, Hyogo 669-1339 (JP)
(74) Representative: Gille Hrabal Struck Neidlein Prop Roos

(56) References cited:
- EP-A- 1 174 868
- EP-A- 1 231 604

## Description

### TECHNICAL FIELD

The present invention relates to a silver alloy sputtering target for forming, by the sputtering process, a semi-transparent reflective layer or a reflective layer (hereinafter collectively referred to as the reflective layer) that constitutes an optical recording medium such as optical recording disk (CD-RW, DVD-RAM, etc.) whereon signals representing audio, visual and/or text information are reproduced, or recorded, reproduced and erased by means of a laser beam emitted by a semiconductor laser or the like.

### BACKGROUND ART

Reflective layers formed from Ag or Ag alloy are used in optical recording media such as magneto-optical recording disks (MD, MO) and optical recording disks (CD-RW, DVD-RAM). The reflective layers formed from Ag or Ag alloy are preferably used due to high reflectivity for light of broad wavelengths ranging from 400 to 830 nm, and particularly high reflectivity for laser beam having a short wavelength used in high density recording of optical recording media.

As a method for forming the reflective layers from Ag or an Ag alloy, it is known to sputter a target made of Ag or the Ag alloy (refer to Japanese Unexamined Patent Application, First Publication No. Hei 11-213448, Japanese Unexamined Patent Application, First Publication No. 2000-109943, and Japanese Unexamined Patent Application, First Publication No. 2000-57627).

EP-A-1 174 868 discloses a target according to the preamble of claim 1.

However, among the optical recording media, in those that have a recording layer formed from a phase change recording material and are subject to repetitive recording, reproducing and erasing, reflectivity of the reflective layer formed from Ag or Ag alloy decreases as the number of repetitions of recording, reproducing and erasing increases, thus failing to endure repetitive recording and reproducing operations over a long period of time.

### DISCLOSURE OF THE INVENTION

The present inventors have found that one of the causes of the problem described above is that, when recording, reproducing and erasing are carried out repetitively on the optical recording medium, the Ag reflective layer is repetitively heated by the irradiation of laser beam and cooled down, during which the Ag reflective layer recrystallizes to cause the crystal grains to grow into coarse grains that result in lower reflectivity.

Accordingly, the present inventors conducted research into ways to obtain an Ag alloy reflective layer that experiences less decrease in reflectivity of the reflective layer as the number of repetitions of recording, reproducing and erasing increases, and found the following facts:
Growth of the crystal grains into coarse grains through repetitive heating by the irradiation with laser beam and cooling down, and hence the resultant decrease in reflectivity, can be minimized through an extended period of use, by using an Ag alloy reflective layer formed by sputtering a silver alloy target that has a composition of 0.5 to 3% by mass of Cu and 0.005 to 0.05% by mass in total of one or more elements selected from among Ca and Be, with the remainder consisting of Ag.

The present invention has been completed based on the research described above, and is characterized by:
A silver alloy sputtering target for forming a reflective layer of optical recording media made of a silver alloy having a composition of 0.5 to 3% by mass of Cu and 0.005 to 0.05% by mass in total of one or more elements selected from among Ca and Be, with the remainder consisting of Ag.

Ca and Be that hardly form a solid solution with Ag are weighed with Ag in such a proportion that the concentration of each element is 0.20% by mass. They are melted in a high-frequency vacuum melting furnace and, after melting, with the furnace filled with Ar gas to atmospheric pressure, and cast in a graphite mold to make a mother alloy that includes Ca and Be. The mother alloy and Cu are added into the weighed Ag, melted and cast into an ingot. Then the target can be made by applying hot working and machining it.

Now the reason will be described for setting the composition of the reflective layer made of the Ag alloy according to the present invention and the sputtering target for forming the reflective layer made of the Ag alloy as described above.
Cu:
   Cu has the effects of increasing the strength of crystal grains by forming a solid solution with Ag, preventing the crystal grains from recrystallizing, thereby to restrain reflectivity from decreasing. Recrystallization of the crystal grains cannot be prevented satisfactorily and therefore reflectivity cannot be prevented from decreasing, when the Cu content is less than 0.5% by mass. When the Cu content is higher than 3% by mass, on the other hand, initial reflectivity of the Ag alloy reflective layer becomes lower. Accordingly, the Cu content in the Ag alloy reflective layer and in the sputtering target for forming the Ag alloy reflective layer is set within the range from 0.5 to 3% by mass (more preferably from 0.5 to 1.5% by mass).
Ca, Be: These components hardly form a solid solution with Ag, and precipitate in the grain boundaries so as to prevent the crystal grains from agglomerating with each other, thereby helping prevent the recrystallization of the Ag alloy reflective layer further. Such an effect cannot be significantly achieved when the content of one or more of these elements is less than 0.005% by mass in total. When the content of one or more of these elements is more than 0.05% by mass in total, on the other hand, the target becomes very hard and difficult to make. Accordingly, the content of these elements in the Ag alloy reflective layer and in the sputtering target for forming the Ag alloy reflective layer is set within the range from 0.005 to 0.05% by mass (more preferably from 0.010 to 0.035% by mass).

### BEST MODE FOR CARRYING OUT THE INVENTION

### Example

Ag, Cu, Ca and Be having a purity of 99.99% by mass or higher were prepared as raw materials. Since Ca and Be hardly form a solid solution with Ag, these elements were weighed with Ag in such a proportion that the concentration of each element became 0.20% by mass. They were melted in a high-frequency vacuum melting furnace and, after melting, with the furnace filled with Ar gas to atmospheric pressure, cast in a graphite mold to make a mother alloy that included Ca and Be.

The mother alloy was added together with Cu to Ag, that was then melted and cast into an ingot. The ingot was heated at 600°C for two hours, then rolled and machined thereby to make targets Nos. 1 through 7 of the present invention, comparative targets Nos. 1 through 4 and prior art target which dimensions were 125 mm in diameter and 5 mm in thickness and having compositions shown in Table 1.

The targets Nos. 1 through 7 of the present invention, the comparative targets Nos. 1 through 4 and the prior art target, which were bonded onto backing plates made of oxygen-free copper with solder, were then set in a DC magnetron sputtering apparatus. After pumping the inside of the DC magnetron sputtering apparatus to vacuum of 1 × 10⁻⁴ Pa, Ar gas was introduced into the apparatus so as to keep a sputtering gas pressure of 1.0 Pa therein. Then DC sputtering power of 100W was supplied from a DC power source to the target, so as to generate plasma in a space between the target and a glass substrate, which dimensions are 30 mm in diameter and 0.5 mm in thickness and which is disposed to oppose the target in parallel to and with a space of 70 mm from the target, thereby to form the Ag alloy reflective layer having thickness of 100 nm.

Reflectivity of the Ag alloy reflective layer formed as described above was measured with a spectrophotometer immediately after being formed. Then after leaving the Ag alloy reflective layer in a temperature and humidity chamber that was controlled to 80°C in temperature and 85% in relative humidity for 200 hours, reflectivity was measured again under the same conditions. Based on the reflectivity data thus obtained, reflectivity to light was determined for wavelengths 400 nm and 650 nm. The results as shown in Table 1 were used to evaluate the durability of the reflective layer as the optical recording medium in recording and reproducing of data.

**Table 1**

| Sample No. | | Composition (% by mass) | | | | Reflectivity to wavelength 400 nm (%) | | Reflectivity to wavelength 650 nm (%) | | Remarks |
|---|---|---|---|---|---|---|---|---|---|---|
| | | Cu | Ca | Be | Ag | Immediately after forming | After 200 hours | Immediately after forming | After 200 hours | |
| Inventive targets | 1 | 0.52 | 0.005 | - | remainder | 89 | 86 | 97 | 94 | |
| | 2 | 1.02 | 0.025 | - | remainder | 86 | 86 | 96 | 96 | |
| | 3 | 1.47 | 0.049 | - | remainder | 83 | 81 | 95 | 93 | |
| | 4 | 0.55 | - | 0.006 | remainder | 89 | 86 | 97 | 95 | |
| | 5 | 1.08 | - | 0.026 | remainder | 86 | 86 | 96 | 96 | |
| | 6 | 1.51 | - | 0.047 | remainder | 83 | 81 | 95 | 92 | |
| | 7 | 0.61 | 0.002 | 0.003 | remainder | 89 | 87 | 97 | 94 | |
| Comparative targets | 1 | 1.01 | 0.003* | - | remainder | 88 | 73 | 97 | 84 | |
| | 2 | 1.03 | - | 0.004* | remainder | 88 | 74 | 97 | 84 | |
| | 3 | 1.04 | 0.06* | - | remainder | - | - | - | - | Unable to form |
| | 4 | 1.03 | - | 0.06* | remainder | - | - | - | - | Unable to form |
| Prior art target | | - | - | - | 100 | 94 | 41 | 98 | 79 | |

From the results shown in the Table, it can be seen that the reflective layers formed by sputtering with the targets Nos. 1 through 7 of the present invention experienced less decrease in reflectivity than the reflective layers formed by sputtering with the comparative targets Nos. 1 through 4 or the prior art target, after being left in a temperature and humidity chamber that was controlled to 80°C in temperature and 85% in relative humidity for 200 hours.

### INDUSTRIAL APPLICABILITY

The reflective layer formed by using the silver alloy sputtering target for forming a reflective layer of optical recording media according to the present invention experiences less decrease in reflectivity caused by aging than the reflective layer formed by using the silver alloy sputtering target for forming a reflective layer of optical recording media of the prior art does, and makes it possible to manufacture optical recording media that can be used over an extended period of time, so as to make great contribution to the development of the recording media industry.

## Claims

1. A silver alloy sputtering target for forming a reflective layer of optical recording media comprising:
a silver alloy having a composition of 0.5 to 3% by mass of Cu;
a further element; and
the remainder consisting of Ag;
**characterized in that**
the further element is of one or more elements selected from among Ca and Be in an amount of 0.005 to 0.05% by mass in total.

2. A reflective layer of optical recording medium formed by using the silver alloy sputtering target according to claim 1.

## Patentansprüche

1. Silberlegierungs-Sputtering-Target zur Bildung einer reflektierenden Schicht eines optischen Aufzeichnungsmediums, umfassend:
eine Silberlegierung, die eine Zusammensetzung aus 0,05 bis 3 Gew.-% Kupfer aufweist;
ein weiteres Element;
wobei der Rest aus Ag besteht;
**dadurch** charakterisiert, dass
das weitere Element ein oder mehr Elemente ist, die ausgewählt werden aus Ca und Be, in einer Menge von 0,005 bis 0,05 Gew.-% insgesamt.

2. Reflektierende Schicht eines optischen Aufzeichnungsmediums, welche durch Verwendung der Silberlegierungs-Sputtering-Target nach Anspruch 1 geformt wird.

## Revendications

1. Cible de pulvérisation d'alliage d'argent pour la formation d'une couche réfléchissante d'un support d'enregistrement optique comprenant :
un alliage d'argent ayant une composition de 0,5 % à 3 % en masse de Cu ;
un autre élément ; et
le reste consistant en Ag ;
**caractérisée en ce que** l'autre élément est un ou plusieurs éléments choisis parmi Ca et Be en une quantité de 0,005 % à 0,05 % en masse au total.

2. Couche réfléchissante de support d'enregistrement optique formée en utilisant la cible de pulvérisation d'alliage d'argent selon la revendication 1.
